# EUROPÄISCHE PATENTSCHRIFT

(11) **EP 0 500 975 B1**
(45) Veröffentlichungstag und Bekanntmachung des Hinweises auf die Patenterteilung: **24.04.1996**
(21) Anmeldenummer: 91102842.1
(22) Anmeldetag: 26.02.1991
(51) Int. Cl.: G01R 1/20, H02M 3/335, H01C 3/02

(54) **Messwiderstand mit Stromanschlüssen und mit wenigstens einem Potentialanschluss**
Measuring resistor with current connections and at least one voltage connection
Résistance de mesure avec des connexions de courant et au moins une connexion de potentiel

(43) Veröffentlichungstag der Anmeldung: 02.09.1992
(73) Patentinhaber: SIEMENS AKTIENGESELLSCHAFT, D-80333 München (DE)
(72) Erfinder: Schwarz, Ulf, Dipl.-Ing., W-8023 Pullach (DE)

(56) Entgegenhaltungen:
- EP-A- 0 265 076
- CA-A- 1 253 570
- DE-A- 3 611 595

## Beschreibung

Die Erfindung bezieht sich auf einen wie im Oberbegriff des Patentanspruchs 1 angegebenen Meßwiderstand mit Stromanschlüssen und mit wenigstens einem Potentialanschluß.

Aus der DE-B1 28 38 009 ist bereits eine Anordnung mit einem Stromwandler bekannt, der als Stromsensor im Hauptstromkreis eines getakteten Stromversorgungsgerätes liegt. Bei dem Stromversorgungsgerät wird ein im Primärkreis angeordneter Schalttransistor durch einen Taktgeber mit Einschaltimpulsen konstanter Arbeitsfrequenz angesteuert. Zur Regelung der Ausgangsspannung wird der Tastgrad, d.h. der Quotient der Einschaltzeit des Leistungsschalttransistors zur Periodendauer verändert. Ferner wird der Schalttransistor gesperrt, sobald der gemessene Momentanwert des durch den Schalttransistor fließenden Stromes einen vorgegebenen Grenzwert übersteigt.

Der bekannte Umrichter enthält zu diesem Zweck eine Strombegrenzungsschaltung mit einem Stromwandler als Stromerfassungsvorrichtung. Dieser Stromerfassungsvorrichtung ist ein RC-Filter als Tiefpaß nachgeschaltet, so daß die Bürdenspannung von Einschaltstromspitzen befreit wird. Auf diese Weise wird vermieden, daß die Sperrung des Schalttransistors fälschlicher Weise vorzeitig durch die Einschaltstromspitze ausgelöst wird.

Allerdings kann das RC-Glied nur für einen bestimmten Strom optimal dimensioniert werden. Die Verwendung eines derartigen Tiefpasses führt daher nur bei vergleichsweise kleinen Strombereichen zum gewünschten Ergebnis.

Man kann andererseits als Stromerfassungsvorrichtung einen Meßwiderstand oder Shunt vorsehen, dessen Spannungsabfall ein Maß für den durch den Widerstand fließenden Strom ist. Da Meßwiderstände eine gewisse Länge haben, kann in vielen Fällen, insbesondere bei hohen Stromanstiegsgeschwindigkeiten, der unvermeidliche induktive Anteil des Spannungsabfalles zu erheblichen Verfälschungen des Stromabbildes führen. Dies kann sich selbst bei ebenen Folienwiderständen, die wegen ihres kleinen Verhältnisses von Länge zu Breite ohnehin eine vergleichsweise niedrige Induktivität besitzen, als sehr störend erweisen.

Aus der Offenlegungsschrift DE 36 11 595 A1 ist eine Anordnung eines elektrischen Widerstandes für Wechselstrom und ein Verfahren zu seiner Herstellung bekannt. Der Meßwiderstand besteht dabei aus einer in einem einzigen Arbeitsgang zusammengefügten Schichtanordnung aus zwei Widerstandsfolien und äußeren Metallplatten, zwischen denen sich isolierende Klebefolien befinden. Zur elektrischen Verbindung der Widerstandsfolien untereinander bzw. mit den Metallplatten dienen streifenförmige Verbindungsschichten am Rande der Klebefolien.

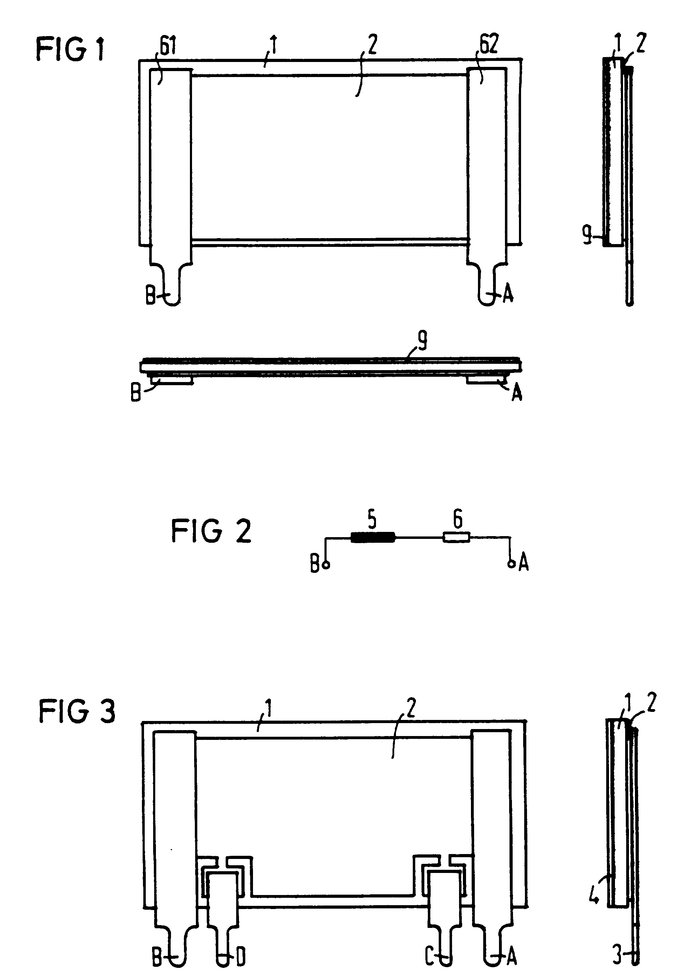

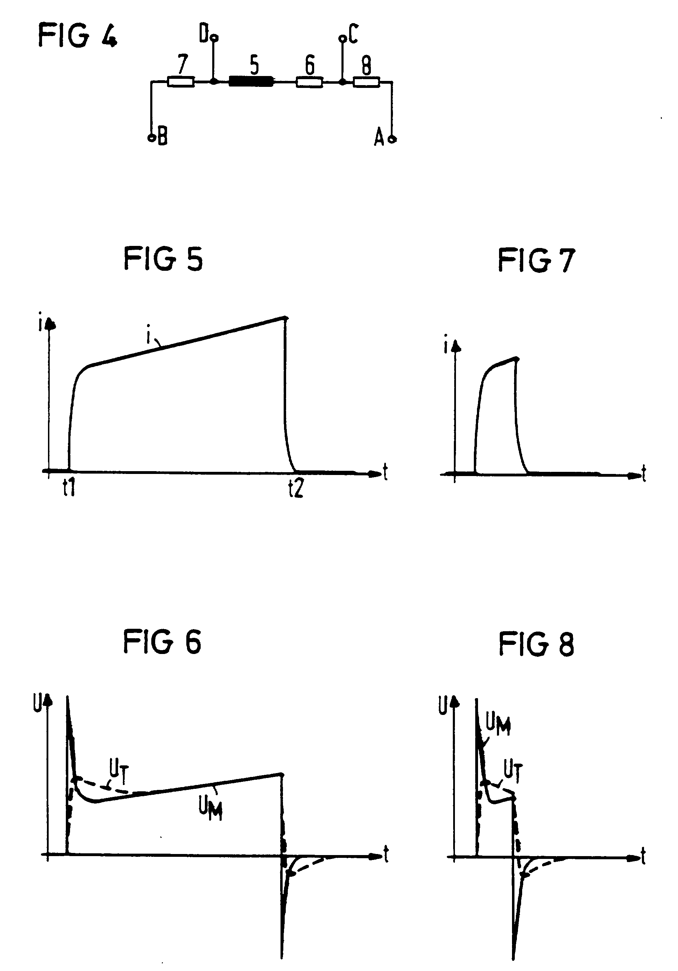

Folienwiderstände bekannter Art sind in den Figuren 1 und 3 gezeigt. Die zugehörigen Ersatzschaltbilder gehen aus den Figuren 2 und 4 hervor.

Die Verfälschung des Stromabbildes äußert scih im Falle eines impulsförmigen Stromes im wesentlichen durch eine deutliche kurzzeitige Spannungsüberhöhung an den Stromflanken. Dieser Sachverhalt ist in den Figuren 5 bis 8 dargestellt.

Ein getreues AbbLld des erfaßten Stromes ist insbesondere bei getakteten Stromversorgungsgeräten mit Momentanwertstrombegrenzung oder Current-Mode-Regelung von großer Bedeutung. Ein getreues Abbild des Stromes ist z.B. auch dann von Interesse, wenn eine aus einem Strom gewonnene Spannung, z.B. mit Hilfe eines Oszillographen zur Anzeige gebracht werden soll.
Man kann bei höheren Strömen Stromwandler einsetzen, die bei entsprechender Messung ein brauchbares Abbild des Primärstromes liefern können. Derartige Stromwandler sind jedoch mit einem vergleichsweise großen Aufwand verbunden. Kappt man, insbesondere bei Verwendung eines Strommeßwiderstandes, die Spitzen im Stromabbild, d.h. die Spitzen der aus dem impulsförmigen Strom gewonnenen impulsförmigen Spannung durch einen nachgeschalteten RC-Tiefpaß, so muß unter Umständen eine so große Zeitkonstante in Kauf genommen werden, daß die Verfälschung, insbesondere bei kleinem Tastgrad, praktisch während des ganzen Strompulses andauert. Die Figuren 5 bis 8 zeigen einen solchen Fall.

Aufgabe der Erfindung ist es, einen wie Oberbegriff des Patentanspruchs 1 angegebenen Meßwiderstand mit Stromanschlüssen und mit wenigstens einem Potentialanschluß derart auszubilden, daß die Meßspannung ein möglichst getreues Abbild des Stromes ist.

Insbesondere soll die Anordnung für getaktete Stromversorgungsgeräte mit Strombegrenzung oder Current-Mode-Regelung geeignet sein, bei denen mit Hilfe der Anordnung aus einer Folge unipolarer Rechteckimpulse eine impulsförmige Spannung zu gewinnen ist.

Überlegungen im Rahmen der Erfindung haben ergeben, daß sich der induktive Spannungsabfall des Meßwiderstandes durch eine gegengerichtete, annähernd identische Spannung kompensieren läßt.

Gemäß der Erfindung wird die Anordnung der eingangs genannten Art in der im kennzeichnenden Teil des Patentanspruchs 1 angegebenen Weise ausgebildet. Dabei wird die gegengerichtete Spannung durch induktive Kopplung mit einem zweiten leitenden Element erzeugt, das Bestandteil des Meßwiderstandes ist.

Durch diese Maßnahmen ergibt sich in vorteilhafter Weise ein Meßwiderstand, dessen Induktivität für die Gewinnung eines Stromabbildes weitgehend kompensiert ist. In Verbindung mit einem getakteten Stromversorgungsgerät ergibt sich der besondere Vorteil, daß sich ein der Anordnung nachgeschalteter Tiefpaß ohne weiteres so dimensionieren läßt, daß keine erhebliche Verfälschung des Signals mehr auftritt.

Vorteilhafte Weiterbildungen der Erfindung ergeben sich aus den Ansprüchen 2 bis 9.

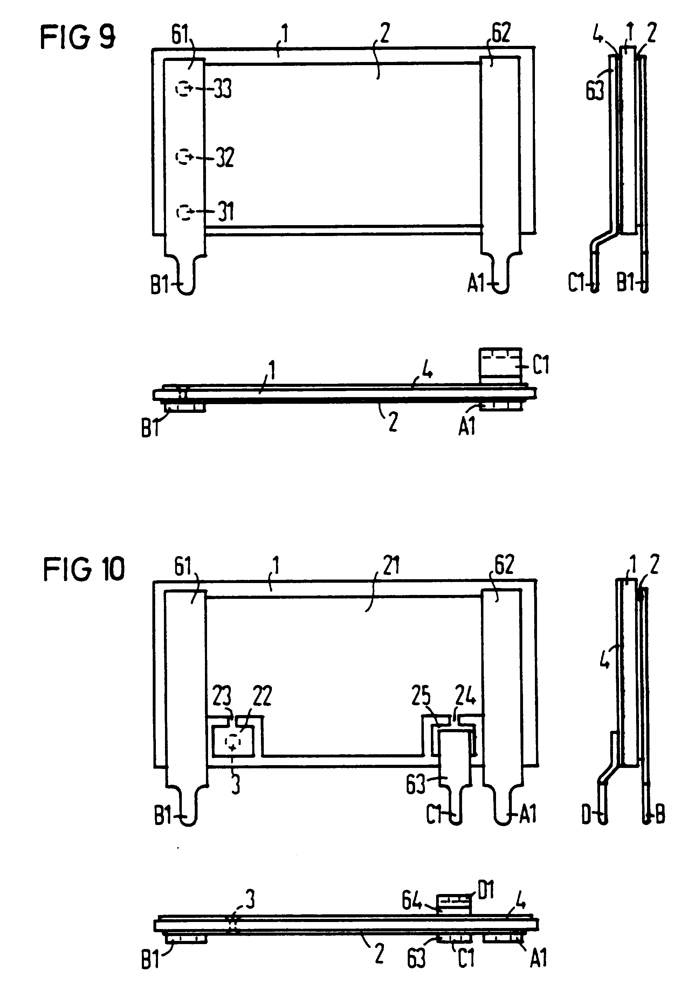

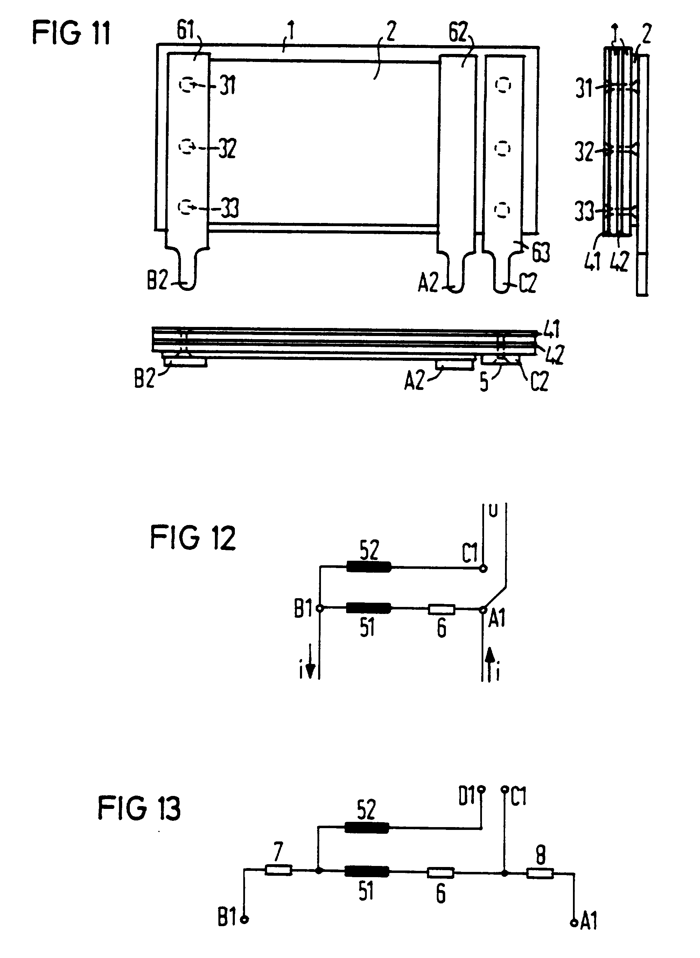

Die Erfindung wird anhand der in den Figuren 1 und 3 gezeigten bekannten Meßwiderstände, der dazugehörigen Ersatzschaltbilder nach Fig. 2 und 4, der in den Figuren 5 und 7 gezeigten Stromdiagramme, der in Figur 6 und 8 gezeigten Spannungsdiagramme, der in den Figuren 9 bis 11 gezeigten Ausführungsbeispiele sowie der Ersatzschaltbilder nach Fig. 12 und 13 näher erläutert.

Es zeigen
- Fig. 1: einen Meßwiderstand bekannter Art,
- Fig. 2: ein Ersatzschaltbild für den Meßwiderstand nach Fig. 1,
- Fig. 3: ein bekannter Meßwiderstand mit zusätzlichen Potentialanschlüssen,
- Fig. 4: ein Ersatzschaltbild für den Meßwiderstand nach Fig. 3,
- Fig. 5: den zeitlichen Verlauf eines nahezu rechteckförmigen Stromimpulses relativ langer Dauer,
- Fig. 6: die zum Strom nach Fig. 1 gehörende Meßspannung vor und hinter einem Tiefpaß,
- Fig. 7: einen nahezu rechteckförmigen Stromimpuls relativ kurzer Dauer,
- Fig. 8: die zum Strom nach Fig. 3 gehörende Meßspannung vor und hinter einem Tiefpaß,
- Fig. 9 bis 11: Meßwiderstände mit Potentialrückführung, und zwar
- Fig. 9: mit zwei Stromanschlüssen und einen Meßanschluß auf seiten einer Potentialanschlußschicht,
- Fig. 10: mit zwei Stromanschlüssen und zwei Meßanschlüssen,
- Fig. 11: mit zwei Stromanschlüssen und einen Meßanschluß auf seiten einer Widerstandsschicht,
- Fig. 12: ein Ersatzschaltbild für den Meßwiderstand nach Fig. 9 und
- Fig. 13: ein Ersatzschaltbild für die Meßwiderstände nach Fig. 10 und Fig. 11.

Die Meßwiderstände bekannter Art nach Fig. 1 und 3 sind als Folienwiderstände ausgebildet.

Bei dem Meßwiderstand nach Fig. 1 ist der plattenförmige Träger 1 auf der einen Seite mit der Widerstandsschicht 1 versehen. Der Träger 1 besteht aus einem Trägerlaminat, die Widerstandsschicht 2 aus einer Widerstandsfolie als Kaschierung. Auf der Widerstandsschicht 2 sind zwei Anschlußstücke 61 und 62 angebracht, die mit der Widerstandsfolie mechanisch und elektrisch leitend verbunden sind.

Die Anschlußstücke 61 und 62 enden in den Stromanschlüssen B und A, mit denen sie in eine Leiterplatte eingesetzt werden können.

Auf der Rückseite des Trägers 1 befindet sich die Kupferauflage 9, die für eine bessere Kühlung des Meßwiderstandes sorgt.

Wie Fig. 2 zeigt, besitzt der Meßwiderstand zusätzlich zum gewünschten ohmschen Widerstand 6 die unerwünschte Induktivität 5. Die Induktivität 5 kann zwar relativ klein gehalten werden, läßt sich jedoch nicht ganz vermeiden.

Bei dem Meßwiderstand nach Fig. 3 ist der plattenförmige Träger 1 auf der einen Seite mit der Widerstandsschicht 1 versehen. Der Träger 1 besteht aus einem Trägerlaminat, die Widerstandsschicht 2 aus einer Widerstandsfolie als Kaschierung. Auf der Widerstandsschicht 2 sind zwei streifenförmige Haltestücke 61 und 62 angebracht, die mit der Widerstandsfolie 2 mechanisch und elektrisch leitend verbunden sind. Zusätzlich sind die beiden Potentialanschlüsse C und D vorgesehen. Der Potentialanschluß C befindet sich neben dem Stromanschluß A, der Potentialanschluß D neben dem Stromanschluß B. Die Potentialanschlüsse C und D sind jeweils auf einer Teilfläche der Widerstandsschicht 2 angeordnet, die jeweils nur über ein stegartiges Stück Widerstandsschicht mit der Hauptfläche der Widerstandsschicht verbunden ist. Auf diese Weise werden definierte Verhältnisse für den Potentialabgriff geschaffen.

Allerdings ist auch hier entsprechend Fig. 4 zwischen den Potentialanschlüssen eine Serienschaltung aus dem gewünschten ohmschen Widerstand 6 und einer unerwünschten Induktivität 5 wirksam. Zusätzlich ist zwischen dem Stromanschluß B, A und dem zugehörigen Potentialanschluß D, C jeweils ein ohmscher Widerstand 7, 8 wirksam. Die theoretisch auch dort vorhandene Induktivität beeinflußt die abgegriffene Meßspannung nicht.

Ausgehend von den Meßwiderständen nach Fig. 1 und 3 zeigt Fig. 5 den zeitlichen Verlauf eines durch den Meßwiderstand als Shunt fließenden Stromes i. Zum Zeitpunkt t1 springt der Strom vom Wert 0 auf einen Anfangswert. Ausgehend von diesem Anfangswert steigt der Strom i rampenförmig bis zum Zeitpunkt t2 an. Zum Zeitpunkt t2 sinkt der Strom auf den Wert 0 ab.

Der in Fig. 7 gezeigte Stromimpuls unterscheidet sich von den nach Fig. 5 dadurch, daß der Zeitbereich, in dem der Strom rampenförmig ansteigt, von wesentlich geringerer Dauer ist.

Fig. 6 zeigt den zeitlichen Verlauf der Meßspannung, die mit Hilfe einer Anordnung zur Stromerfassung aus dem in Fig. 5 gezeigten Strom gewonnen wird. Auffällig sind die zur Anstiegsflanke des Stromimpulses gehörende positive Spannungsspitze und die zur Abstiegsflanke des Stromimpulses gehörende negative Spannungsspitze. Die mit Hilfe eines Tiefpasses aus der Meßspannung U_{M} gewonnene korrigierte Meßspannung U_{T} ist strichliert dargestellt. Wie die strichlierte Darstellung zeigt, sind die Spannungsspitzen deutlich verringert. Dies wird allerdings damit erkauft, daß die Spannung am Ausgang des Tiefpasses nur gegen Ende des Impulses dem rampenförmig ansteigenden Verlauf des Stromimpulses entspricht. Wie aus Fig. 8 hervorgeht, kann die Verfälschung der Meßspannung durch den Tiefpaß im Falle eines vergleichsweise kurzen Stromimpulses während der gesamten Impulsdauer fortbestehen. Im Beispiel nach den Figuren 7 und 8 wird sogar aus dem rampenförmigen Anstieg des Stromes ein rampenförmiger Abfall der korrigierten Meßspannung.

Derartige Verhältnisse sind insbesondere dann nicht tragbar, wenn die Anordnung zur Gewinnung einer einem Strom proportionalen Spannung Bestandtteil der Stromerfassungsvorrichtung eines getakteten Stromversorgungsgerätes mit Strombegrenzung oder Current-Mode-Regelung ist. Insbesondere für eine Current-Mode-Regelung ist ein getreues Abbild des Primärstromes von wesentlicher Bedeutung.

Die in den Figuren 9 bis 11 gezeigten Meßwiderstände gestatten es, die störende Induktivität im wesentlichen zu kompensieren und so die genannten Schwierigkeiten bei der Stromerfassung wirksam zu vermeiden.

Die hochbelastbaren Folienwiderstände nach Fig. 9 bis 11 bestehen jeweils aus einem leiterplattenähnlichen Trägerlaminat mit einer darauf aufgebrachten Folie aus Widerstandsmaterial, z.B. Manganin. Zur besseren Wärmeableitung sind in das Trägermaterial noch eine oder mehrere flächige Metallschichten, vorzugsweise Kupfer, ein- bzw. aufgebracht, ähnlich einer Mehrlagenleiterplatte. Benützt man eine dieser Lagen, vorzugsweise diejenige, die der stromführenden Folie am nächsten liegt, als Rückleitung für das abgegriffene Potential, so wird die in dieser Rückleitung durch die induktive Kopplung induzierte, dem induktiven Spannungsabfall des Widerstandes näherungsweise gleich große Spannung von der Meßspannung subtrahiert, so daß annähernd nur der ohmsche Anteil übrig bleibt.

Für den Meßwiderstand nach Fig. 9 gilt in erster Näherung das Ersatzschaltbild nach Fig. 12. Der Meßwiderstand hat die Stromanschlüsse A1 und B1 für den zu meßenden Strom i und die Potentialanschlüsse C und D für die gewonnene Meßspannung u.

Der Träger 1 besteht ganz oder teilweise aus Isolierstoff, derart, daß wenigstens eine isolierende Schicht vorhanden ist. Der Träger 1 trägt auf der Vorderseite die Widerstandsschicht 2, die aus einem Widerstandsmaterial, vorzugsweise aus einer Widerstandsfolie besteht. Auf der Rückseite des Trägers 1, d.h. in räumlich paralleler Anordnung befindet sich die Potentialrückführungsschicht 4, die aus einem elektrisch leitenden Werkstoff, insbesondere aus Kupfer besteht.

Die Widerstandsschicht 2 ist in einander gegenüberliegenden Endbereichen mit den Stromanschlüssen A1 und B1 versehen. Vorzugsweise bestehen der Träger 1 aus einem Trägerlaminat, die Widerstandsschicht 2 aus einer Widerstandsfolie als Kaschierung und die Potentialzuführungsschicht 4 aus einer Kupferkaschierung.

Die Widerstandsschicht 2 ist von rechteckförmiger Gestalt und bedeckt einen rechteckförmigen Teil des Trägers 1. In den Endbereichen der Widerstandsschicht ist jeweils ein Anschlußstück 61 bzw. 62 auf der Widerstandsschicht 2 so angebracht, daß der Träger 1 zu beiden Seiten der Anschlußstücke 61 und 62 nach außen etwas übersteht.

Die Anschlußteile 61 und 62 sind von bandförmiger Gestalt und mit der Widerstandsschicht 2 mechanisch und elektrisch leitend verbunden. Die Anschlußstücke 61 und 62 sind vorzugsweise als Blechstücke ausgebildet, die längs der Schmalseiten des rechteckförmigen Trägers 1 liegend auf der Widerstandsschicht angebracht und vorzugsweise durch Lötung mit dieser verbunden sind. Sie enden in den stiftartigen Stromanschlüssen A1 und B1.

In der Nähe des einen Trägerendes sind die Widerstandsschicht und die Potentialrückführungsschicht 4, die durch den isolierenden Träger voneinander isoliert sind, durch die drei elektrischen Verbindungen 31, 32 und 33 miteinander verbunden. Diese elektrischen Verbindungen sind als Durchkontaktierungen ausgebildet, die durch den Träger 1 hindurchgreifen und die Widerstandsschicht 2 und die auf der Rückseite des Trägers 1 befindliche Potentialanschlußschicht 4 elektrisch miteinander verbinden.

Das andere Anschlußstück 62 ist nur mit der Widerstandsschicht 2 elektrisch und mechanisch verbunden.

Auf der Rückseite des Trägers 1 ist dem Anschlußstück 62 gegenüberliegend das zusätzliche Anschlußstück 63 angebracht. Der Potentialanschluß C1 und der Stromanschluß A1, der zugleich als zweiter Potentialanschluß dient, sind auf der Vorder- und Rückseite des Trägers 1 einander gegenüberliegend, d.h. miteinander fluchtend angeordnet. Das Anschlußstück 63 liegt auf der Potentialrückführungsschicht 4 flächig auf und ist in seinem Endbereich derart gekröpft, daß sich zwischen dem Potentialanschluß C1 und dem Stromanschluß B1 ein im Vergleich zur Dicke des Trägers 1 größerer Abstand ergibt. Das Anschlußstück 63 endet in dem stiftartigen Potentialanschluß C1.

Der Meßwiderstand nach Fig. 10 stimmt hinsichtlich seines Grundaufbaus mit dem nach Fig. 9 überein. Abweichend von Fig. 9 ist nur eine elektrische Verbindung 3 zwischen der Widerstandsschicht 2 und der Potentialrückführungsschicht 4 vorgesehen. Weitere Unterschiede bestehen darin, daß die elektrische Verbindung 3 neben dem Anschlußstück 61 angebracht ist und daher das Anschlußstück 61 nicht mit umfaßt. Außerdem ist die Widerstandsschicht 2 mit einem dritten Anschlußstück 63 versehen.

Die elektrische Verbindung 3 ist zwischen der Potentialrückführungsschicht 4 und der Teilfläche 22 der Widerstandsschicht 2 angeordnet. Die Teilfläche 22 der Widerstandsschicht 2 ist nach Art eines Lötauges ausgebildet und als solches nur über das stegartige Stück 23 Widerstandsschicht mit der Hauptfläche 21 der Widerstandsschicht 2 verbunden.

Neben dem Stromanschluß A1, und dabei zwischen den beiden Stromanschlüssen A1 und B1, ist auf der Teilfläche 25 der Widerstandsschicht 2 das Anschlußstück 63 für den Potentialanschluß C1 angeordnet. Die Teilfläche 25 der Widerstandsschicht 2 ist nur über das stegartige Stück 24 Widerstandsschicht mit der Hauptfläche 21 der Widerstandsschicht 2 verbunden.

Auf der Potentialrückführungsschicht 4 ist das Anschlußstück 64 für den anderen Potentialanschluß D1 angeordnet. Die Anschlußstücke 63 und 64 sind auf der Vorder- und Rückseite des Trägers 1 gegenüberliegend, vorzugsweise miteinander fluchtend angeordnet.

Auch der Meßwiderstand nach Fig. 11 stimmt hinsichtlich seines Grundaufbaus mit dem nach Fig. 9 überein. Abweichend ist in dem den elektrischen Verbindungen 31...33 gegenüberliegenden Endbereich auf Seiten der Widerstandsschicht 2 nebeneinander das innere, mit der Widerstandsschicht 2 elektrisch verbundene Anschlußstück 62 für den Stromanschluß A2 und das von der Widerstandsschicht 2 isolierte und mit den Potentialrückführungsschichten 41 und 42 elektrisch verbundene äußere Anschlußstück 63 für den Potentialanschluß C2 vorgesehen.

Außerdem besteht der Träger 1 aus einem Laminat, das mehrere Zurückführungsschichten 41 und 42 aufweist. Die Zurückführungsschichten 41 und 42 sind vorzugsweise als Kupferlagen ausgebildet.

Wie das Ersatzschaltbild 12 des Meßwiderstandes nach Fig. 9 und das Ersatzschaltbild 13 der Meßwiderstände nach den Figuren 10 und 11 zeigen, ist die störende Induktivität 52 jeweils durch die damit induktiv gekoppelte weitere Induktivität weitgehend kompensiert.

Die in den Figuren gezeigten Meßwiderstände können zu ihrem Schutz zweckmäßigerweise mit einer Umhüllung versehen werden, die der besseren Übersichtlichkeit halber nicht dargestellt ist.

## Patentansprüche

1. Meßwiderstand mit Stromanschlüssen (A, B) für einen zu messenden Strom und mit wenigstens einem Potentialanschluß für die gewonnene Meßspannung, wobei ein wenigstens zum Teil aus Isolierstoff bestehender Träger (1) eine Widerstandsschicht (2) aus einem Widerstandsmaterial trägt und die Widerstandsschicht (2) in einander gegenüberliegenden Endbereichen mit den Stromanschlüssen (A, B) versehen ist,
**dadurch gekennzeichnet,**
daß räumlich parallel zur Widerstandsschicht (2) wenigstens eine Potentialrückführungsschicht (4) aus elektrisch leitendem Material angeordnet ist und
daß die durch das Isoliermaterial voneinander isolierten Schichten (2, 4) in einem der Endbereiche mittels wenigstens einer elektrische Verbindung (3; 31, 32, 33) miteinander verbunden und im anderen Endbereich mit wenigstens einem Potentialanschluß (C1, D1; C2) versehen sind.

2. Meßwiderstand nach Anspruch 1,
**dadurch gekennzeichnet,**
daß die elektrische Verbindung (3; 31...33) zwischen der Widerstandsschicht (2) und der bzw. den Potentialrückführungsschichten (4) jeweils als eine durch den Träger (1) hindurchgreifende Durchkontaktierung ausgebildet ist.

3. Meßwiderstand nach Anspruch 2,
**dadurch gekennzeichnet,**
daß eine elektrische Verbindung (3) vorgesehen ist, die zwischen der Potentialrückführungsschicht (4) und einer Teilfläche (22) der Widerstandsschicht (2) angeordnet ist, und daß die Teilfläche (22) der Widerstandsschicht (2) nur über ein stegartiges Stück (23) Widerstandsschicht mit der Hauptfläche (21) der Widerstandsschicht (2) verbunden ist.

4. Meßwiderstand nach Anspruch 2,
**dadurch gekennzeichnet,**
daß zwischen der Widerstandsschicht (2) und der Potentialrückführungsschicht (4) mehrere elektrische Verbindungen (31...33) vorgesehen sind, die jeweils die Widerstandsschicht (2) mit dem darauf befindlichen Stromanschluß und die vorgesehene Anzahl der Potentialrückführungsschichten (41, 42) miteinander verbinden.

5. Meßwiderstand nach Anspruch 2,
**dadurch gekennzeichnet**,
daß im Bereich des der elektrischen Verbindung (3) gegenüberliegenden Stromanschlußes (A1) zwischen den beiden Stromanschlüssen (A1, B1) auf der Widerstandsschicht (2) der eine Potentialanschluß (C1) und gegenüberliegend auf der Potentialrückführungsschicht (4) ein weiterer Potentialanschluß (D1) angeordnet ist.

6. Meßwiderstand nach Anspruch 2,
**dadurch gekennzeichnet**,
daß in dem der elektrischen Verbindung (3) gegenüberliegenden Endbereich auf Seiten der Widerstandsschicht (2) nebeneinander ein innerer, mit der Widerstandsschicht (2) elektrisch verbundener Stromanschluß (A2) und ein von der Widerstandsschicht (2) isolierter und mit der vorgesehenen Zahl der Potentialrückführungsschichten (41, 42) elektrisch verbundener Potentialanschluß (C2) vorgesehen ist.

7. Meßwiderstand nach Anspruch 5,
**dadurch gekennzeichnet**,
daß der eine Potentialanschluß (C1) auf einer Teilfläche (25) der Widerstandsschicht (2) angeordnet ist, und daß die Teilfläche (25) der Widerstandsschicht (2) nur über ein stegartiges Stück (24) Widerstandsschicht mit der Hauptfläche (21) der Widerstandsschicht (2) verbunden ist.

8. Meßwiderstand nach einem der Ansprüche 1 bis 7,
**dadurch gekennzeichnet**,
daß der Träger (1) aus einem Laminat besteht, das mehrere Kupferlagen aufweist, und daß die Kupferlagen die Potentialrückführungsschichten (41, 42) bilden.

9. Meßwiderstand nach einem der Ansprüche 1 bis 8,
**dadurch gekennzeichnet**,
daß die Widerstandsschicht (2) aus einer Widerstandsfolie besteht.

## Claims

1. Measuring resistor with current connections (A, B) for a current which is to be measured and with at least one potential connection for the measurement voltage obtained, a carrier (1), which is at least partially made of insulating material, being fitted with a resistance coating (2) made of a resistance material, and the resistance coating (2) being provided in mutually opposite end regions with the current connections (A, B), characterized in that at least one potential feedback coating (4) made of electrically conductive material is arranged physically parallel to the resistance coating (2), and in that the coatings (2, 4), which are insulated from one another by the insulating material, are connected to one another in one of the end regions by means of at least one electrical connection (3; 31, 32, 33) and are provided in the other end region with at least one potential connection (C1, D1; C2).

2. Measuring resistor according to Claim 1, characterized in that the electrical connection (3; 31...33) between the resistance coating (2) and the potential feedback coating or coatings (4) is in each case designed as through-plating which passes through the carrier (1).

3. Measuring resistor according to Claim 2, characterized in that an electrical connection (3) is provided which is arranged between the potential feedback coating (4) and a part of the surface (22) of the resistance coating (2), and in that the part of the surface (22) of the resistance coating (2) is connected to the main surface (21) of the resistance coating (2) only via a web-like piece (23) of resistance coating.

4. Measuring resistor according to Claim 2, characterized in that a plurality of electrical connections (31...33) are provided between the resistance coating (2) and the potential feedback coating (4), which electrical connections (31...33) in each case connect the resistance coating (2) to the current connection located thereon and connect the number of potential feedback coatings (41, 42) provided to one another.

5. Measuring resistor according to Claim 2, characterized in that one potential connection (C1) is arranged on the resistance coating (2), between the two current connections (A1, B1), in the region of that current connection (A1) which is opposite the electrical connection (3), and a further potential connection (D1) is arranged opposite on the potential feedback coating (4).

6. Measuring resistor according to Claim 2, characterized in that an inner current connection (A2), which is electrically connected to the resistance coating (2), and a potential connection (C2), which is insulated from the resistance coating (2) and is electrically connected to the number of potential feedback coatings (41, 42) provided, are provided side by side on the side of the resistance coating (2) in the end region opposite the electrical connection (3).

7. Measuring resistor according to Claim 5, characterized in that one potential connection (C1) is arranged on a part of the surface (25) of the resistance coating (2), and in that the part of the surface (25) of the resistance coating (2) is connected to the main surface (21) of the resistance coating (2) only via a web-like piece (24) of resistance coating.

8. Measuring resistor according to one of Claims 1 to 7, characterized in that the carrier (1) is made of a laminate which has a plurality of copper layers, and in that the copper layers form the potential feedback coatings (41, 42).

9. Measuring resistor according to one of Claims 1 to 8, characterized in that the resistance coating (2) is made of a resistance film.

## Revendications

1. Résistance de mesure comportant des bornes électriques (A, B) pour un courant à mesurer, et au moins une borne de potentiel pour la tension de mesure obtenue, un support (1) au moins en partie en un matériau isolant portant une couche (2) de résistance en un matériau résistif et des zones d'extrémité en face l'une de l'autre de la couche (2) de résistance étant munies de bornes électriques (A, B),
caractérisée en ce que
au moins une couche (4) de retour de potentiel en un matériau conducteur de l'électricité est montée parallèlement dans l'espace à la couche (2) de résistance,
les couches (2, 4) isolées l'une de l'autre par le matériau isolant sont reliées l'une à l'autre dans l'une des zones d'extrémité au moyen d'au moins une liaison électrique (3 ; 31, 32, 33) et sont munies dans l'autre zone d'extrémité d'au moins une borne (C1, D1 ; C2) de potentiel.

2. Résistance de mesure suivant la revendication 1,
caractérisée en ce que
la liaison électrique (3 ; 31 à 33) entre la couche (2) de résistance et la ou les couches (4) de retour de potentiel sont sous la forme de trous métallisés traversant le support (1).

3. Résistance de mesure suivant la revendication 2,
caractérisée en ce que
il est prévu une liaison (3) électrique, qui est montée entre la couche (4) de retour de potentiel et une couche partielle (22) de la couche (2) de résistance et la partie de la surface (22) de la couche (2) de résistance n'est reliée à la couche (21) principale de la couche (2) de résistance que par une partie (23) en forme de barrette de couche de résistance.

4. Résistance de mesure suivant la revendication 2,
caractérisée en ce que
il est prévu entre la couche (2) de résistance et la couche (4) de retour de potentiel plusieurs liaisons électriques (31 à 33), qui relient la couche (2) de résistance à la borne électrique qui se trouve sur elle et qui relient entre elles le nombre prévu de couches (41, 42) de retour de potentiel.

5. Résistance de mesure suivant la revendication 2,
caractérisée en ce que
il est monté dans la zone de la borne électrique (A1), qui est en face de la liaison électrique (3), entre les deux bornes électriques (A1, B1) une borne (C1) de potentiel sur la couche (2) de résistance et en face sur la couche (4) de retour de potentiel une autre borne (D1) de potentiel.

6. Résistance de mesure suivant la revendication 2,
caractérisée en ce que
une borne (A2) électrique intérieure reliée électriquement à la couche (2) de résistance et une borne (C2) de potentiel isolée de la couche (2) de résistance et reliée électriquement au nombre prévu de couches (41, 42) de retour de potentiel sont prévues l'une à côté de l'autre dans la zone d'extrémité en face de la liaison électrique (3) sur des côtés de la couche (2) de résistance.

7. Résistance de mesure suivant la revendication 5,
caractérisée en ce que
l'une (C1) des bornes de potentiel est montée sur une partie (25) de la surface de la couche (2) de résistance et la partie (25) de la surface de la couche (2) de résistance n'est reliée à la surface principale (21) de la couche (2) de résistance que par l'intermédiaire d'une partie (24), en forme de barrette, de la couche de résistance.

8. Résistance de mesure suivant l'une des revendications 1 à 7,
caractérisée en ce que
le support (1) est constitué d'un stratifié qui comprend plusieurs couches de cuivre et les couches de cuivre forment les couches (41, 42) de retour de potentiel.

9. Résistance de mesure suivant l'une des revendications 1 à 8,
caractérisée en ce que
la couche (2) de résistance est constituée d'une pellicule de résistance.
